# EUROPEAN PATENT APPLICATION

(11) **EP 2 103 710 A1**
(43) Date of publication of application: **23.09.2009**
(21) Application number: 07850705.0
(22) Date of filing: 17.12.2007
(51) Int. Cl.: C23C 14/06, C23C 14/08, C23C 14/14, C23C 14/34, H01L 41/187, H01L 41/22

(54) **METHOD FOR FORMING MULTILAYER FILM AND APPARATUS FOR FORMING MULTILAYER FILM**

(30) Priority: 20.12.2006 JP 2006343259
(71) Applicant: ULVAC, INC., Chigasaki-shi Kanagawa 253-8543 (JP)
(72) Inventor: KIMURA, Isao, Susono-shi Shizuoka 410-1231 (JP); JINBO, Takehito, Susono-shi Shizuoka 410-1231 (JP); KIKUCHI, Shin, Susono-shi Shizuoka 410-1231 (JP); NISHIOKA, Yutaka, Susono-shi Shizuoka 410-1231 (JP); SUU, Koukou, Susono-shi Shizuoka 410-1231 (JP)
(74) Representative: Barth, Stephan Manuel
(86) International application number: PCT/JP2007/074217
(87) International publication number: WO 2008/075641

(57) **Abstract**

A multilayer thin film formation method and a multilayer thin film formation apparatus that improve dielectric characteristics and piezoelectric characteristics of a thin film formed from a lead-based perovskite complex oxide. The multilayer thin film formation method includes formation of a lower electrode layer (32b) containing a noble metal above a substrate (S) by sputtering a lower electrode layer target (TG2), and superposing a lead-based complex oxide layer (33) on the lower electrode layer (32b) by sputtering an oxide layer target (TG3) containing lead. The lower electrode layer (32b) has a thickness restricted to 10 to 30 nm, and the lead-based complex oxide layer (33) has a thickness restricted to 0.2 and 5.0 µm.

## Description

### TECHNICAL FIELD

The present invention relates to a method for forming a multilayer film and an apparatus for forming a multilayer film.

### BACKGROUND ART

Lead-based perovskite complex oxides (hereinafter simply referred to as lead-based complex oxides) have superior piezoelectric characteristics and dielectric characteristics and are thus used in various types of electronic devices such as sensors and actuators. In the prior art, various types of elements including lead-based complex oxides are formed by machining a sinter of lead-based complex oxides.

Over recent years, in the field of electronic device fabrication, due to the miniaturization of electronic devices and progress in MEMS (Micro Electro Mechanical Systems) technology, thinner films of lead-based complex oxides are in demand. Known processes used to obtain thinner films of lead-based complex oxides include sputtering, sol-gel, CVD, and laser abrasion. However, thin films of lead-based complex oxides obtained through such processes all have difficulties in obtaining sufficient dielectric characteristics and piezoelectric characteristics compared to lead-based complex oxides obtained through machining.

In the field for manufacturing thin films of lead-based complex oxides, proposals have been made to improve the piezoelectric characteristics and the dielectric characteristics in the prior art. Patent document 1 discloses the formation of a thin film of lead zirconate titanate (PZT) having a thickness that is greater than the desired film thickness in advance. A lead (Pb) excess layer is removed from the surface of a PZT thin film by performing reverse sputter etching. This processes the PZT thin film to the desired film thickness. In this case, the piezoelectric characteristics and the dielectric characteristics of the PZT thin film may be improved in accordance with the removed amount of the Pb excess layer. Patent document 2 discloses the improvement of the piezoelectric characteristics and the dielectric characteristics by adding at least one of V, Nb, C, N, or BN to the elements composing a PZT thin film.

Lead-based complex oxides generally exhibit the desired dielectric characteristics and piezoelectric characteristics only when in the perovskite phase. In the metastable pyrochlore phase, the permittivity becomes lower than the perovskite phase and piezoelectric characteristics are subtly exhibited.

If a thin film of lead-based complex oxides is deposited on an electrode layer, a pyrochlore phase forms at the interface between the lead-based complex oxide layer and the electrode layer. Once formed, the transition of a lead-based complex oxide layer in the pyrochlore phase to the perovskite phase is difficult even when performing high-temperature annealing process. Thus, when reducing the thickness of a lead-based complex oxide layer (e.g., to 5 µm or less), the thin film of lead-based complex oxides deteriorates the dielectric characteristics and piezoelectric characteristics due to the influence of the pyrochlore phase.

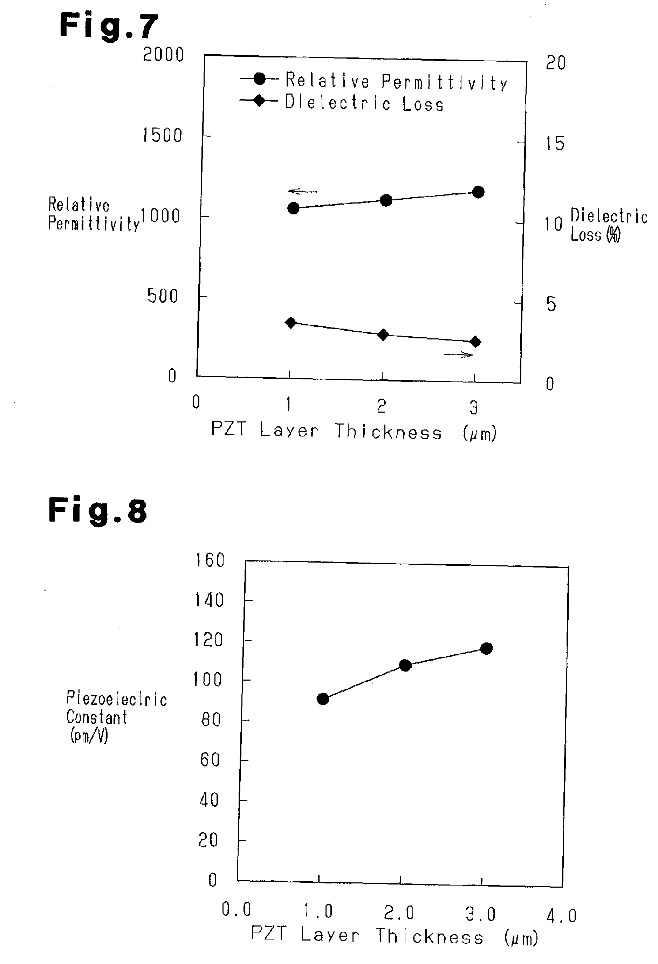

Fig. 7 shows a relative permittivity and dielectric loss with respect to the thickness of the PZT layer. Fig. 8 shows a piezoelectric constant with respect to the film thickness of the PZT layer. As shown in Figs. 7 and 8, the PZT layer lowers the relative permittivity and increases the dielectric loss since the influence of the pyrochlore phase becomes greater as the film thickness becomes thinner. Further, the PZT layer lowers the piezoelectric constant as the film thickness becomes thinner.

As a result, a thinner film of lead-based complex oxide deteriorates the dielectric characteristics and piezoelectric characteristics. This adversely affects the electrical characteristics of the electronic device.
[Patent Document 1] Japanese Laid-Open Patent Publication No. 7-109562
[Patent Document 2] Japanese Laid-Open Patent Publication No. 2003-212545

### DISCLOSURE OF THE INVENTION

The present invention provides a method for forming a multilayer thin film and an apparatus for forming a multilayer thin film that improves the dielectric characteristics and the piezoelectric characteristics of a thin film composed of lead perovskite complex oxides.

A first aspect of the present invention is a multilayer film formation method for forming a multilayer film including an electrode layer and a lead-based perovskite complex oxide layer. The method includes forming the electrode layer above a substrate by sputtering a first target containing a noble metal, and superposing the lead-based perovskite complex oxide layer on the electrode layer by sputtering a second target containing lead. The forming the electrode layer includes forming the electrode layer with a thickness of 10 to 30 nm.

A second aspect of the present invention is a multilayer film formation apparatus provided with a first film formation unit which includes a first target containing a noble metal and sputters the first target to form an electrode layer above a substrate. A second film formation unit includes a second target containing lead and sputters the second target to form a lead-based perovskite complex oxide layer on the electrode layer. A transfer unit is connected to the first film formation unit and the second film formation unit and transfers the substrate to the first film formation unit and the second film formation unit. A control unit drives the transfer unit, the first film formation unit, and the second film formation unit. The control unit drives the first formation unit to form the electrode layer with a thickness of 10 to 30 nm above the substrate.

### BRIEF DESCRIPTION OF THE DRAWINGS

Fig. 1 is a plan view schematically showing one embodiment of a film formation apparatus;
Fig. 2 is a block circuit diagram showing the electrical configuration of the film formation apparatus of Fig. 2;
Fig. 3(a) is a diagram showing a process for manufacturing a lower electrode layer of a multilayer film;
Fig. 3(b) is a diagram showing a process for manufacturing a lead-based complex oxide layer of the multilayer film;
Fig. 3(c) is a diagram showing a process for manufacturing an upper electrode layer of the multilayer film;
Fig. 4 is a diagram showing an X-ray diffraction spectrum of the multilayer film;
Fig. 5 is a diagram showing the relative permittivity and dielectric loss of the multilayer film;
Fig. 6 is a diagram showing the piezoelectric constant of the multilayer film;
Fig. 7 is a diagram showing the relative permittivity and a dielectric loss of a multilayer film in a prior art example; and
Fig. 8 is a diagram showing the piezoelectric constant in the prior art conventional example.

### BEST MODE FOR CARRYING OUT THE INVENTION

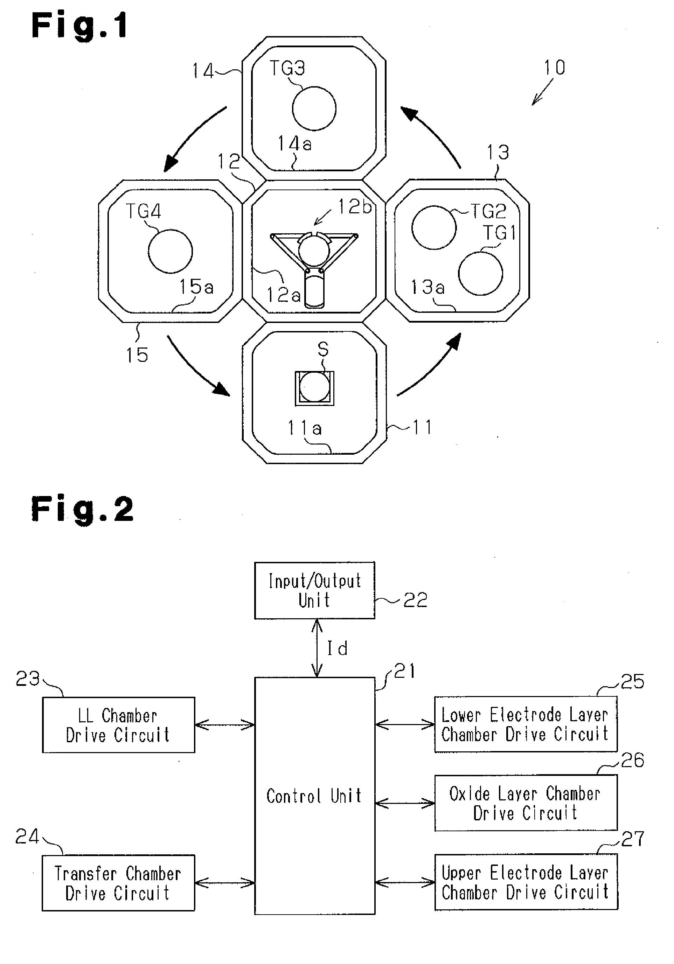

One embodiment of an apparatus for forming a multilayer film according to the present invention will now be discussed. Fig. 1 is a plan view schematically showing a film formation apparatus 10 serving as an apparatus for forming a multilayer film.

As shown in Fig. 1, the film formation apparatus 10 includes a load lock chamber (hereinafter simply referred to as the LL chamber) 11 and a transfer chamber 12 connected to the LL chamber 11 and forming a transfer unit. The film formation apparatus 10 also includes a lower electrode layer chamber 13 serving as a first film formation unit, an oxide layer chamber 14 serving as a second film formation unit, and an upper electrode layer chamber 15, which are all connected to the transfer chamber 12

The LL chamber 11 includes a depressurizable inner area (hereinafter simply referred to as an accommodation compartment 11a), which accommodates a plurality of substrates S so that they can be transferred into and out of the accommodation compartment 11a. Silicon substrates, ceramic substrates, and the like may be used as the substrates S. When starting a film formation process for the substrates S, the LL chamber 11 depressurizes the accommodation compartment 11a so that the plurality of substrates S are transferrable out of the transfer chamber 12. After the film formation process for the substrates S ends, the LL chamber 11 opens the accommodation compartment 11a to the atmosphere so that the accommodated substrates S are transferrable out of the film formation apparatus 10.

The transfer chamber 12 includes an inner area (hereinafter simply referred to as a transfer compartment 12a), which is communicable with the accommodation compartment 11a. A transfer robot 12b is installed in the transfer compartment 12a to transfer the substrates S. When the film formation process for the substrate S starts, the transfer robot 12b loads the substrates S, which are yet to undergo the film formation process, from the LL chamber 11 to the transfer chamber 12. Then, the transfer robot 12b transfers the loaded substrates S in an order in the counterclockwise direction as viewed in Fig. 1, that is, in an order of the lower electrode layer chamber 13, the oxide layer chamber 14, and the upper electrode layer chamber 15. After the film formation process for the substrates S ends, the transfer robot 12b loads the substrates S, which have undergone the film formation process, out of the transfer chamber 12 and into the LL chamber 11.

The lower electrode layer chamber 13 includes an inner area (hereinafter simply referred to as a film formation compartment 13a), which is communicable with the transfer compartment 12a. The film formation compartment 13a includes an adhesion layer target TG1. Sputtering is performed in the lower electrode layer chamber 13 to sputter the adhesion layer target TG1 and form an adhesion layer on a substrate S, which is held at a predetermined temperature (e.g., a temperature of 500°C or higher). A thin film of titanium (Ti), tantalum (Ta), nickel (Ni), cobalt (Co), zirconium (Zr), or an oxide of these substances (TiO₂, Ta₂O₅ etc.) may be used to forms the adhesion layer. The lower electrode layer chamber 13 further includes a lower electrode layer target TG2 serving as a first target mounted in the film formation compartment 13a. Sputtering is performed in the lower electrode layer chamber 13 to sputter the lower electrode layer target TG2 and form a lower electrode layer on the adhesion layer of the substrate S, which is held at a predetermined temperature (e.g., a temperature of 500°C or higher). In the lower electrode layer target TG2, the content of the main components of the lower electrode layer, that is, noble metals such as platinum (Pt), gold (Au), and silver (Ag) is 90% or greater and preferably 95% or greater. The remaining portions of the lower electrode layer target TG2 contain metals other than the metal element of the main components, such as copper and silicon. Various types of sputtering may be performed in the lower electrode layer chamber 13, such as a DC or AC sputtering process and DC or AC magnetron processes.

The oxide layer chamber 14 includes an inner area (hereinafter referred to as a film formation compartment 14a), which is communicable with the transfer compartment 12a. The film formation compartment 14a includes an oxide layer target TG3 serving as a second target. Sputtering is performed in the oxide layer chamber 14 to sputter the oxide layer target TG3 and form a layer of lead-based complex oxides (lead-based perovskite complex oxides) on a substrate S, which is held at a predetermined temperature (e.g. a temperature of 500°C or higher). A sinter of lead-based perovskite complex oxides such as the main components of the lead-based complex oxide, that is, lead zirconate titanate (Pb(Zr, Ti)O₃:PZT), lead strontium titanate (Pb(Sr, Ti)O₃:PST), lead lanthanum zirconium titanate (Pb, La)(Zr, Ti)O₃:PLZT), and the like may be used for the oxide layer target TG3. Alternatively, an alloy target of lead-zirconium-titanium for forming lead zirconate titanate (Pb(Zr, Ti)O₃:PZT) and the like may be used for the oxide layer target TG3. That is, the oxide layer chamber 14 is a chamber for forming a thin film of lead-based perovskite complex oxides by performing sputtering. Various types of sputtering may be performed in the oxide layer chamber 14, such as a DC or AC sputtering process and DC or AC magnetron processes.

The upper electrode layer chamber 15 includes an inner area (hereinafter simply referred to as a film formation compartment 15a), which is communicable with the transfer compartment 12a. The film formation compartment 15a includes an upper electrode layer target TG4. Sputtering is performed in the upper electrode layer chamber 15 to sputter the upper electrode layer target and forms an upper electrode layer on a substrate S, which is held at a predetermined temperature (e.g., a temperature of 500°C or higher). In the upper electrode layer target TG4, the contents of the main components of the upper electrode layer, that is, noble metal such as platinum (Pt), gold (Au), and silver (Ag) is 90% or greater and preferably 95% or greater. The remaining portions of the upper electrode layer target TG4 contain metals other than the metal element of the main components, such as copper and silicon.

The electrical configuration of the film formation apparatus 10 will now be described. Fig. 2 is an electric block circuit diagram showing the electrical configuration of the film formation apparatus 10.

As shown in Fig. 2, a control unit 21 executes with the film formation apparatus 10 various processes (e.g., transfer process for the substrates S, film formation process for the substrate S, etc.). The control unit 21 includes a CPU for executing various calculations, a RAM for storing various types of data, a ROM for storing various control programs, a hard disk, and the like. The control unit 21 reads out a film formation process program from the hard disk to execute the film formation process in accordance with the film formation process program.

The control unit 21 is connected to an input/output unit 22. The input/output unit 22 includes various types of operation switches, such as a start switch and a stop switch, and various types of display devices, such as a liquid crystal display. The input/output unit 22 provides the control unit 21 with data used in various processing operations and outputs data related to the processing status of the film formation apparatus 10. The input/output unit 22 provides the control unit 21 with data related to film formation parameters (e.g., gas flow rate for sputtering, film formation pressure, film formation temperature, film formation time, etc.) as film formation condition data Id. In other words, the input/output unit 22 provides the control unit 21 with various film formation parameters to form the adhesion layer, the lower electrode layer, the lead-based complex oxide, and the upper electrode layer as the film formation condition data Id. The control unit 21 executes a film formation process for each layer under film formation conditions that correspond to the film formation condition data Id provided from the input/output unit 22.

The control unit 21 is connected to an LL chamber drive circuit 23, which controls and drives the LL chamber 11. The LL chamber drive circuit 23 detects the state of the LL chamber 11 and provides the detection result to the control unit 21. For example, the LL chamber drive circuit 23 detects the pressure value of the accommodation compartment 11a and provides the control unit 21 with a detection signal related to the pressure value. Based on the detection signal provided from the LL chamber drive circuit 23, the control unit 21 provides the LL chamber drive circuit 23 with a corresponding drive control signal. In response to the drive control signal from the control unit 21, the LL chamber drive circuit 23 depressurizes or opens the accommodation compartment 11a to the atmosphere so that substrates S can be loaded into and out of the accommodation compartment 11 a.

The control unit 21 is connected to a transfer chamber drive circuit 24, which controls and drives the transfer chamber 12. The transfer chamber drive circuit 24 detects the state of the transfer chamber 12 and provides the detection result to the control unit 21. For example, the transfer chamber drive circuit 24 detects an arm position of the transfer robot 12b and provides the control unit 21 with a detection signal related to the arm position. Based on the detection signal provided from the transfer chamber drive circuit 24, the control unit 21 provides the transfer chamber drive circuit 24 with a corresponding drive control signal. In response to the drive control signal from the control unit 21, the transfer chamber drive circuit 24 transfers the substrates S in accordance with a film formation process program in the order of the LL chamber 11, the transfer chamber 12, the lower electrode layer chamber 13, the oxide layer chamber 14, and the upper electrode layer chamber 15.

The control unit 21 is connected to a lower electrode layer chamber drive circuit 25, which controls and drives the lower electrode layer chamber 13. The lower electrode layer chamber drive circuit 25 detects the state of the lower electrode layer chamber 13 and provides the detection result to the control unit 21. For example, the lower electrode layer chamber drive circuit 25 detects parameters such as the actual pressure of the film formation compartment 13a, the actual flow rate of sputter gas, the actual temperature of the substrate S, the process time, and the value of the actual power applied to the target. Then, the lower electrode layer chamber drive circuit 25 provides the control unit 21 with detection signals related to the parameters. Based on the detection signals provided from the lower electrode layer chamber drive circuit 25, the control unit 21 provides the lower electrode layer chamber drive circuit 25 with a drive control signal corresponding to the film formation condition data Id. In response to the drive control signal from the control unit 21, the lower electrode layer chamber drive circuit 25 executes film formation processes for the adhesion layer and the lower electrode layer under the film formation condition corresponding to the film formation condition data Id.

The control unit 21 is connected to an oxide layer chamber drive circuit 26, which controls and drives the oxide layer chamber 14. The oxide layer chamber drive circuit 26 detects the state of the oxide layer chamber 14 and provides the detection result to the control unit 21. For example, the oxide layer chamber drive circuit 26 detects parameters such as the actual pressure of the film formation compartment 14a, the actual flow rate of sputter gas, the actual temperature of the substrate S, the process time, and the value of the actual power applied to the target. Then, the oxide layer chamber drive circuit 26 provides the control unit 21 with detection signals related to the parameters. Based on the detection signals provided from the oxide layer chamber drive circuit 26, the control unit 21 provides the oxide layer chamber drive circuit 26 with a drive control signal corresponding to the film formation condition data Id. In response to the drive control signal from the control unit 21, the oxide layer chamber drive circuit 26 executes a film formation process for the lead-based complex oxides under the film formation condition corresponding to the film formation condition data Id.

The control unit 21 is connected to an upper electrode layer chamber drive circuit 27, which controls and drives the upper electrode layer chamber 15. The upper electrode layer chamber drive circuit 27 detects the state of the upper electrode layer chamber 15 and provides the detection result to the control unit 21. For example, the upper electrode layer chamber drive circuit 27 detects parameters such as the actual pressure of the film formation compartment 15a, the actual flow rate of sputter gas, the actual temperature of the substrate S, the process time, and the value of the actual power applied to the target. Then, the upper electrode layer chamber drive circuit 27 provides the control unit 21 with the detection signals related to the parameters. Based on the detection signal provided from the upper electrode layer chamber drive circuit 27, the control unit 21 provides the upper electrode layer chamber drive circuit 27 with a drive control signal corresponding to the film formation condition data Id. In response to the drive control signal from the control unit 21, the upper electrode layer chamber drive circuit 27 executes a film formation process for the upper electrode layer under the film formation condition corresponding to the film formation condition data ld.

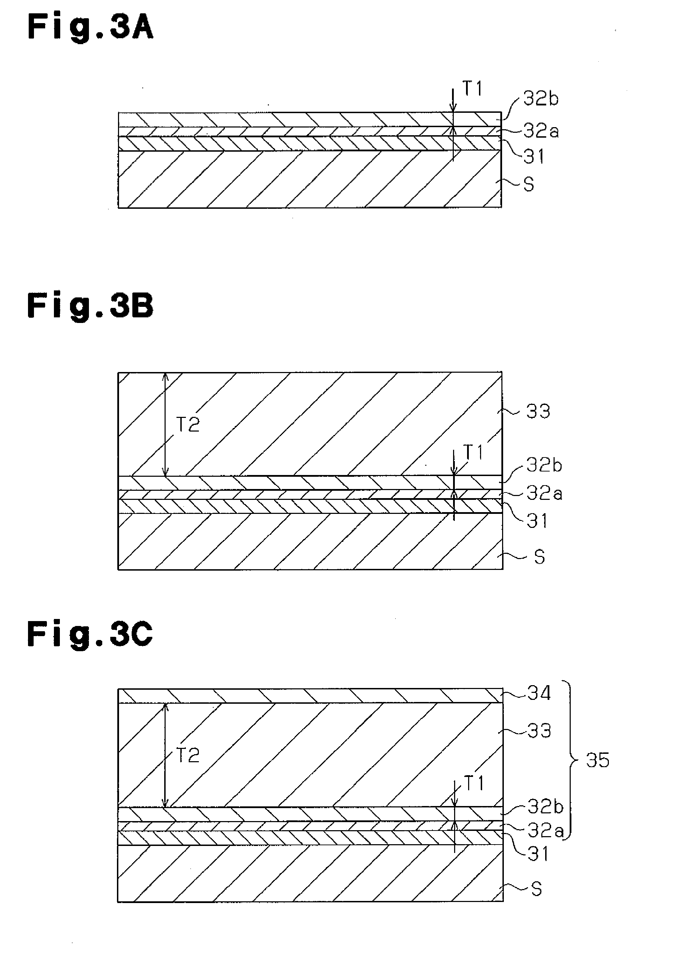

A method for forming a multilayer film with the film formation apparatus 10 will now be discussed. Fig. 3(a) to Fig. 3(c) are diagrams showing processes for forming the multilayer film.

First, the substrates S are set in the LL chamber 11. In this case, each substrate S has a surface on which an underlayer 31 (e.g., silicon oxide film) is formed, as shown in Fig. 3(a). When receiving the film formation condition data Id from the input/output unit 22, the control unit 21 drives the LL chamber 11 and the transfer chamber 12 with the LL chamber drive circuit 23 and the transfer chamber drive circuit 24 to transfer a substrate S from the accommodation compartment 11 a to the lower electrode layer chamber 13.

When the substrate S is loaded into the film formation compartment 13a of the lower electrode layer chamber 13, the control unit 21 superposes an adhesion layer 32a and a lower electrode layer 32b on the upper side of the underlayer 31, as shown in Fig. 3(a). In other words, the control unit 21 drives the lower electrode layer chamber 13 with the lower electrode layer chamber drive circuit 25 to superpose the adhesion layer 32a and the lower electrode layer 32b under a film formation condition corresponding to the film formation condition data Id.

The lower electrode layer 32b has a thickness referred to as a lower electrode layer thickness T1. The lower electrode layer chamber 13 forms the lower electrode layer 32b based on the film formation condition data Id so that the lower electrode layer thickness T1 is 10 to 30 nm. For instance, the control unit 21 measures the process time for forming the lower electrode layer 32b with the lower electrode layer chamber drive circuit 25. Then, the control unit 21 ends the film formation process at a timing at which the process time reaches a predetermined film formation time so that the lower electrode layer thickness T1 is adjusted to 10 to 30 nm.

By forming the lower electrode layer 32b with a thickness of 30 nm or less, lead diffusion of a lead-based complex oxide layer 33 is reduced when the lead-based complex oxide layer 33 is formed on the lower electrode layer 32b in a subsequent process. This avoids a state in which lead is lost from the lead-based complex oxide.

Furthermore, by forming the lower electrode layer 32b with a thickness of 10 nm or greater, a selection ratio for etching between the lead-based complex oxide layer 32 and the lower electrode layer 32b is ensured when etching the lead-based complex oxide layer 33 in a subsequent process. For instance, if the thickness difference (thickness variation) of the lead-based complex oxide layer 33 is 45 nm and the lower electrode layer thickness T1 is 10 nm, the selection ratio for etching between the lead-based complex oxide layer 33 and the lower electrode layer 32b may be in a range of greater than 4.5. Thus, sufficient processability is obtained for the lead-based complex oxide layer 33. If the film thickness difference (variation in film thickness) of the lead-based complex oxide layer 33 is 45 nm and the lower electrode layer thickness T1 is 30 nm, the selection ratio for etching between the lead-based complex oxide layer 33 and the lower electrode layer 32b may be lowered to 1.5.

After the lower electrode layer 32b is formed, the control unit 21 superposes the lead-based complex oxide layer 33 on the upper side of the lower electrode layer 32b, as shown in Fig. 3(b). In other words, the control unit 21 drives the transfer chamber 12 with the transfer chamber drive circuit 24 and transfers the substrate S from the lower electrode layer chamber 13 to the oxide layer chamber 14. The control unit 21 then drives the oxide layer chamber 14 with the oxide layer chamber drive circuit 26 and superposes the lead-based complex oxide layer 33 under the film formation condition corresponding to the film formation condition data Id.

The thickness of the lead-based complex oxide layer 33 is referred to as an oxide layer thickness T2. The oxide layer chamber 14 forms the lead-based complex oxide layer 33 based on the film formation condition data Id so that the oxide layer thickness T2 is 0.2 to 5.0 µm. For instance, the control unit 21 measures the process time for forming the lead-based complex oxide layer 33 with the oxide layer chamber drive circuit 26 and ends the film formation process at a timing at which the process time reaches a predetermined formation time so that the oxide layer thickness T2 is adjusted to 0.2 to 5.0 µm.

Consequently, the thickness of the lead-based complex oxide layer 33 is restricted to a value that is sufficiently greater than that of the lower electrode layer 32b. This further ensures improvement in the dielectric characteristics and piezoelectric characteristics of the lead-based complex oxide layer.

After the lead-based complex oxide layer 33 is formed, the control unit 21 superposes the upper electrode layer 34 on the upper side of the lead-based complex oxide layer 33, as shown in Fig. 3(c). In other words, the control unit 21 drives the transfer chamber 12 with the transfer chamber drive circuit 24 and transfers the substrate S from the oxide layer chamber 14 to the upper electrode layer chamber 15. The control unit 21 then drives the upper electrode layer chamber 15 with the upper electrode layer chamber drive circuit 27 to superpose the upper electrode layer 34 under the film formation condition corresponding to the film formation condition data Id. This forms a multilayer film 35 including the adhesion layer 32a, the lower electrode layer 32b, the lead-based complex oxide layer 33, and the upper electrode layer 34.

After the upper electrode layer 34 is formed, the control unit 21 transfers the substrate S out of the film formation apparatus 10. In other words, the control unit 21 drives the transfer chamber 12 with the transfer chamber drive circuit 24 to transfer the substrate S from the upper electrode layer chamber 15 to the LL chamber 11. Afterward, in the same manner, the control unit 21 drives the chambers 11 to 15 with the drive circuits 23 to 27 to superpose the adhesion layer 32a, the lower electrode layer 32b, the lead-based complex oxide layer 33, and the upper electrode layer 34 on every one of the substrates S. Then, the substrates S are held in the LL chamber 11. After every one of the substrates S undergo the film formation process, the control unit 21 opens the LL chamber 11 to the atmosphere with the LL chamber drive circuit 23 and transfers all of the substrates S out of the film formation apparatus 10.

The present invention will now be discussed using an example and comparative example.

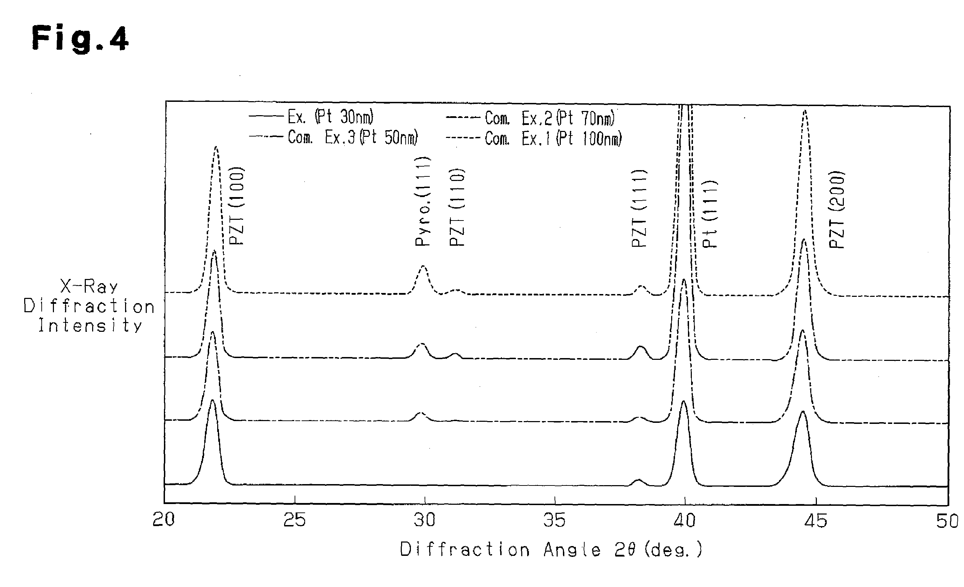

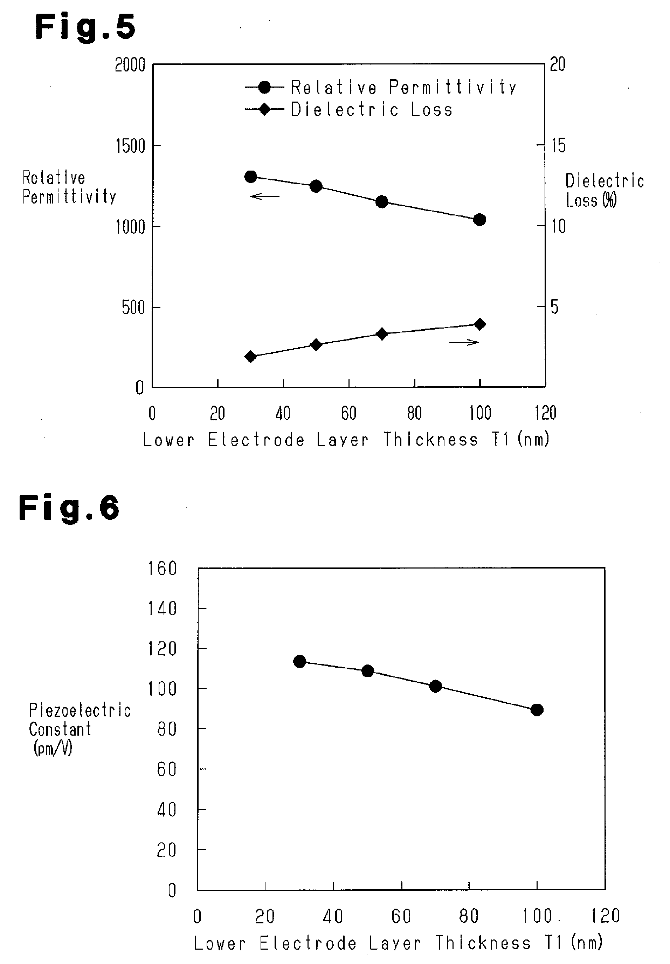

Fig. 4 shows an X-ray diffraction spectrum for the multilayer film 35 obtained with the film formation apparatus 10. Fig. 5 shows the relative permittivity and the dielectric loss with respect to the film thickness of the lower electrode layer 32b, and Fig. 6 shows the piezoelectric constant with respect to the film thickness of the lower electrode layer 32b.

### [Example]

A silicon oxide film having a film thickness of 1 µm was formed as the underlayer 31 using a silicon substrate having a diameter of 150 mm as the substrate S.

As the film formation condition of the adhesion layer 32a and the lower electrode layer 32b, targets of which main components were Ti and Pt were used, respectively. Further, Ar gas was used as the sputtering gas. While holding the temperature of the substrate S at 500°C, the adhesion layer 32a, of which main component was Ti and of which film thickness was 20 nm, and the lower electrode layer 32b, of which main component was Pt and of which film thickness was 30 nm, were sequentially superposed on the underlayer 31.

As the film formation condition for the lead-based complex oxide layer 33, a target of which main component was lead zirconate titanate (Pb(Zr_{0.52}Ti_{0.48})O₃) was used . Further, Ar gas and O₂ gas were respectively used as the sputter gas and the reaction gas. While holding the temperature of the substrate S at 550°C, the lead-based complex oxide layer 33, of which main component was lead zirconate titanate (Pb(Zr, Ti)O₃:PZT) and of which film thickness was 1.0 µm, was formed.

As the film formation condition of the upper electrode layer 34A, a target of which main components was Pt was used. The upper electrode layer 34, of which main component was Pt and of which film thickness was 100 nm, was superposed on the lead-based complex oxide layer 33. By performing the processes described above, the multilayer film 35 of the example was obtained.

For the multilayer film 35 of the above-described example, the X-ray diffraction spectrum was measured with an X-ray diffraction device, and the relative permittivity and the dielectric loss were measured using a permittivity measurement device. Further, for the multilayer film 35 of the above-described example, the piezoelectric constant was also measured using a piezoelectric constant measurement device. The piezoelectric constant measurement device measured the piezoelectric constant by applying predetermined AC power between the lower electrode layer 32b and the upper electrode layer 34 of the multilayer film 35, which was formed to have, for example, a cantilever shape, and measuring deflection at the distal end of the multilayer film 35 with a laser Doppler vibration gauge.

### [Comparative Examples]

As the film formation condition for the lower electrode layer 32b, a target of which main component was Pt was used. Further, Ar gas was used as the sputter gas. Three substrates S were used to form the lower electrode layer 32b, of which main components was Pt, on each substrate S. The three lower electrode layers 32b were formed to respectively have a film thickness of 100 nm, 70 nm, and 50 nm. The multilayer films 35 were formed in comparative examples 1 to 3 using the same film formation conditions as the example except for the film formation condition of the lower electrode layer 32b. The lower electrode layer 32b of the multilayer film 35 in comparative example 1 has a film thickness of 100 nm, the lower electrode layer 32b of the multilayer film 35 in comparative example 2 has a film thickness of 70 nm, and the lower electrode layer 32b of the multilayer film 35 in comparative example 3 has a film thickness of 50nm. In the same manner as the above-described example, the X-ray diffraction spectrum, the relative permittivity, the dielectric loss, and the piezoelectric constant were measured for each comparative example 1 to 3.

Fig. 4 is a graph showing the X-ray diffraction intensity for the example and comparative examples 1 to 3. The horizontal axis and the vertical axis indicate the diffraction angle 2θ of the X-ray and the X-ray diffraction intensity, respectively.

The (111) plane of Pt forming the lower electrode layer 32b was commonly recognized in the example and comparative examples 1 to 3 at a position corresponding to the diffraction angle 2θ of approximately 40°. Furthermore, the (100) plane, the (110) plane, the (111) plane, and the (200) plane corresponding to the perovskite phase of the lead-based complex oxide layer 33 (PZT) were commonly recognized in the example and comparative examples 1 to 3 at positions corresponding to the diffraction angle 2θ of approximately 22°, approximately 32°, approximately 38°, and approximately 44°.

The (111) plane corresponding to the pyrochlore phase of the lead-based complex oxide layer 33 (PZT) was commonly recognized only in comparative examples 1 to 3 at the position corresponding to the diffraction angle 2θ of approximately 29°. Specifically, in each of comparative examples 1 to 3, the intensity of the (111) plane of the pyrochlore phase decreased relative to the intensity of each plane of the perovskite phase. The extent of such decrease becomes larger in the order of comparative example 1, comparative example 2, and comparative example 3, that is, in the thinning order of the film thickness of the lower electrode layer 32b. In the example, the (111) plane of the pyrochlore phase recognized in the comparative examples 1 to 3 was lost.

Therefore, it can be recognized that the pyrochlore phase of the lead-based complex oxide layer 33 is lost or becomes sufficiently thin relative to the perovskite phase by forming the lower electrode layer 32b with a film thickness of 30 nm or less.

As shown in Fig. 5, the relative permittivity increases as the thickness of the lower electrode layer thickness T1 becomes less. In other words, among comparative examples 1 to 3 and the example, the value of the relative permittivity is the highest in the example in which the lower electrode layer thickness T1 is 30 nm. The dielectric loss decreases as the lower electrode layer thickness T1 becomes less. In other words, the dielectric loss of the example is the lowest among comparative examples 1 to 3 and the example. Therefore, it can be recognized that the dielectric characteristics of the lead-based complex oxide layer 33 are improved when the lower electrode layer thickness T1 is 30 nm or less.

As shown in Fig. 6, the piezoelectric constant increases as the lower electrode layer thickness T1 becomes less. In other words, among comparative examples 1 to 3 and the example, the piezoelectric constant is the highest in the example having the lower electrode layer thickness T1 of 30 nm. Therefore, it can be recognized that the piezoelectric characteristics of the lead-based complex oxide layer 33 are improved when lower electrode layer thickness T1 is 30 nm or less.

The method for forming the multilayer film in the embodiment has the advantages described below.
(1) The method for forming the multilayer film in the embodiment includes a process for forming the lower electrode layer 32b from a noble metal on the substrate S by sputtering the lower electrode layer target and a process for sputtering the oxide layer target containing lead to superpose the lead-based complex oxide layer 33 on the lower electrode layer 32b. In the process of forming the lower electrode layer 32b, the thickness of the lower electrode layer 32b is restricted to be 10 to 30 nm.
   The lead-based perovskite complex oxide 33 shifts to the pyrochlore phase due to the loss of lead. The inventors have found that by decreasing the thickness of the electrode layer 32b or the base of the lead-based complex oxide 33, the diffusion of lead from the lead-based perovskite complex oxide 33 is suppressed and the growth of the pyrochlore phase is thereby avoided. In the prior art, the lower electrode layer of the lead-based perovskite complex oxide is generally used with a film thickness that is greater than 100 nm. The inventors have found that by restricting the film thickness of the lower electrode layer to 30 nm or less, the growth of the pyrochlore phase is sufficiently suppressed and the dielectric characteristics and piezoelectric characteristics of the lead perovskite complex oxide are improved.
   In the embodiment, the selection ratio of etching between the lower electrode layer 32b and the lead-based complex oxide layer 33 is ensured by restricting the film thickness of the lower electrode layer 32b to 10 nm or greater. This ensures the processability of the lead-based complex oxide layer 33. Therefore, the diffusion of lead is suppressed without adversely affecting the processability of the lead-based complex oxide layer 33. Furthermore, the lead-based complex oxide layer 33 is maintained in the perovskite phase. This improves the dielectric characteristics and the piezoelectric characteristics of the lead-based complex oxide layer 33 of which thickness is decreased.
(2) The thickness of the lead-based complex oxide layer 33 is restricted to 0.2 to 5.0 µm. This forms the lead-based complex oxide layer 33 with a sufficient thickness relative to the film thickness of the lower electrode layer 32b of which thickness has been reduced. Thus, the dielectric characteristics and piezoelectric characteristics of the multilayer film 35 are further ensured.
(3) A target of which a main component is platinum is sputtered to form the lower electrode layer 32b of which main component is platinum on a substrate S heated to 500°C or greater. Then, a target of which a main component is lead zirconate titanate is sputtered to form the lead-based complex oxide layer 33 of which main component is lead zirconate titanate on the lower electrode layer 32b.

The orientation of the lead zirconate titanate is optimized since the lower electrode layer 32b is heated to 500°C or greater. Thus, the lead zirconate titanate of the Perovskite phase is grown more smoothly. This improves the dielectric characteristics and piezoelectric characteristics of the lead zirconate titanate of which thickness has been reduced.

The above-described embodiment may be practiced in the form described below.

In the above-described embodiment, single target sputtering is employed to use and sputter a single target for each of the adhesion layer 32a, the lower electrode layer 32b, the lead-based complex oxide layer 33, and the upper electrode layer 34. However, the present invention is not limited in such a manner, and multi-target sputtering for using and sputtering a plurality of targets may be applied.

## Claims

1. A multilayer film formation method for forming a multilayer film including an electrode layer and a lead-based perovskite complex oxide layer, the method comprising:
forming the electrode layer above a substrate by sputtering a first target containing a noble metal; and
superposing the lead-based perovskite complex oxide layer on the electrode layer by sputtering a second target containing lead;
wherein said forming the electrode layer includes forming the electrode layer with a thickness of 10 to 30 nm.

2. The multilayer film formation method according to claim 1, wherein said superposing the lead-based perovskite complex oxide layer includes superposing the lead-based perovskite complex oxide layer with a thickness of 0.2 to 5.0 µm.

3. The multilayer film formation method according to claim 1 or 2, wherein:
said forming the electrode layer includes:
heating the substrate to 500°C or greater; and
sputtering a target of which a main component is platinum to form the electrode layer with the thickness of 10 to 30 nm on the heated substrate; and said superposing the lead-based perovskite complex oxide layer includes:
sputtering a target of which a main component is lead zirconate titanate to form the lead-based perovskite complex oxide layer with the thickness of 0.2 to 5.0 µm on the electrode layer.

4. A multilayer film formation apparatus comprising:
a first film formation unit which includes a first target containing a noble metal and sputters the first target to form an electrode layer above a substrate;
a second film formation unit which includes a second target containing lead and sputters the second target to form a lead-based perovskite complex oxide layer on the electrode layer;
a transfer unit which is connected to the first film formation unit and the second film formation unit and which transfers the substrate to the first film formation unit and the second film formation unit; and
a control unit which drives the transfer unit, the first film formation unit, and the second film formation unit, wherein the control unit drives the first formation unit to form the electrode layer with a thickness of 10 to 30 nm above the substrate.

5. The multilayer film formation apparatus according to claim 4, wherein the control unit drives the second film formation unit to superpose the lead-based perovskite complex oxide layer with a thickness of 0.2 to 5.0 µm on the electrode layer.

6. The multilayer film formation apparatus according to claim 4 or 5, **characterized in that**
the first target is a target of which a main component is platinum;
the second target is a target of which a main component is lead zirconate titanate; and
the control unit drives the first film formation unit so as to form the electrode layer of which main component is the platinum with the thickness of 10 to 30 nm on the substrate heated to 500°C or greater and drives the second film formation unit to superpose the lead-based perovskite complex oxide layer of which main component is the lead zirconate titanate with the thickness of 0.2 to 5.0 µm on the electrode layer.
